Europäisches Patentamt

European Patent Office

Office européen des brevets

(11) Publication number: **0 360 263**
**A2**

## EUROPEAN PATENT APPLICATION

(21) Application number: **89117459.1**

(22) Date of filing: **21.09.89**

(51) Int. Cl.⁵: **H03K 17/95**

(30) Priority: **22.09.88 JP 238047/88**

(43) Date of publication of application:
**28.03.90 Bulletin 90/13**

(84) Designated Contracting States:
**AT BE CH DE ES FR GB GR IT LI LU NL SE**

(71) Applicant: **OMRON TATEISI ELECTRONICS CO.**
**10, Tsuchido-cho Hanazono Ukyo-ku Kyoto(JP)**

(72) Inventor: **Honda, Ryuji Omron Tateisi Electronics Co.**
**Patent Dept. 20 Igadera Shimokaiinji Nagaokakyo-City Kyoto 617(JP)**
Inventor: **Yoichi, Sugiyama Omron Tateisi Electronics Co.**
**Patent Dept. 20 Igadera Shimokaiinji Nagaokakyo-City Kyoto 617(JP)**

(74) Representative: **WILHELMS, KILIAN & PARTNER Patentanwälte**
**Eduard-Schmid-Strasse 2**
**D-8000 München 90(DE)**

(54) Self-diagnosing proximity switch.

(57) This invention relates to a self-diagnosing proximity switch. This switch comprising two sets of circuits outputs a fault detection signal in the event of disagreement of outputs from the respective sets of circuits and even in the event of such a fault, can continue to output a normal object detection signal.

EP 0 360 263 A2

# SELF-DIAGNOSING PROXIMITY SWITCH

## BACKGROUND OF THE INVENTION

### Field of the Invention

The present invention relates to a proximity switch having a self-dianosing function which, in the event of a fault or partial failure, may output a fault signal.

### Description of the Prior Art

Conventional high-frequency proximity switch keeps oscillating at all times and detects the approach of an object from the termination of its oscillation output but cannot detect whether the termination of oscillation is due to the approach of an object or that due to a fault in the switch.

### Summary of the Invention

It is an object of the present invention to provide a proximity switch which not only outputs an object detection signal even in the presence of a fault but also a fault signal.

The present invention relates to a proximity switch having a self-diagnosing function such that even in the presence of a partial fault, a fault signal may be outputted. This invention comprises a first and a second detection coil, a first and a second oscillation circuit connected to said first and second detection coils, respectively, a first and a second oscillation judging means adapted to judge the oscillation states of said first and second oscillation circuits, respectively, a disagreement judging circuit which detects a disagreement between the outputs of said first and second oscillation judging means, and a signal output means for outputting an object detection signal according to the logical sum of outputs from said first and second oscillation judging means.

### BRIEF DESCRIPTION OF THE DRAWINGS

The above and other objects, advantages and features of this invention will be more fully understood when considered in conjunction with the following figures, wherein:

Fig. 1 is a block diagram showing the construction of a self-diagnosing promixity switch embodying the first invention;

Fig. 2 is a time chart showing the operation of the same switch;

Fig. 3 is a block diagram showing the construction of a self-diagnosing proximity switch embodying the second invention; and

Fig. 4 is a time chart showing the operation of the same switch.

## DETAILED DESCRIPTION OF THE PREFERRED EMBODIMENTS

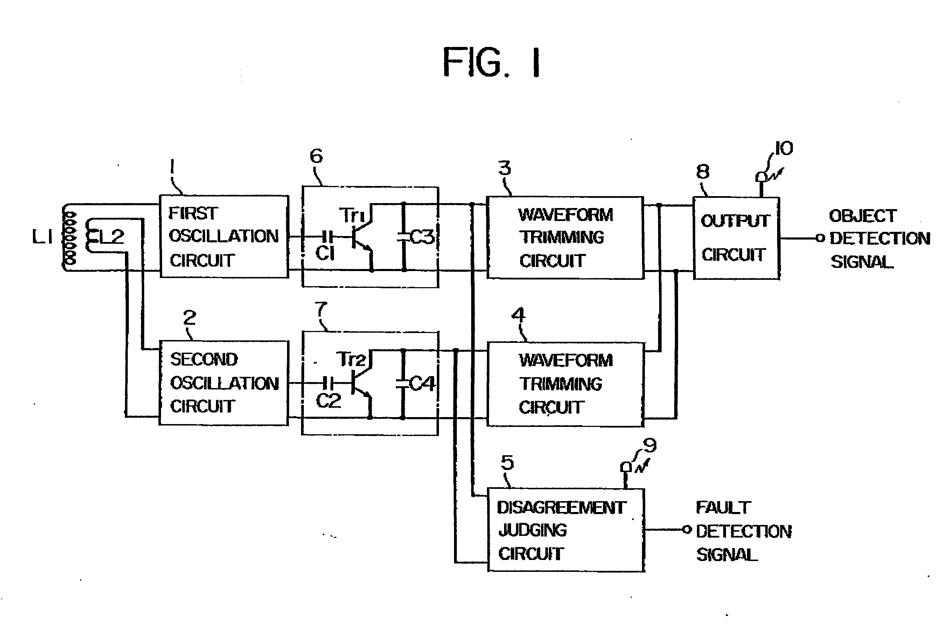

Fig. 1 is a block diagram showing the construction of a self-diagnosing proximity switch embodying the principle of the invention. As shown, the proximity switch has a first and a second detection coil, L1 and L2, which are connected to a first and second oscillation circuits 1 and 2. The oscillation circuits keep oscillating concurrently at a constant frequency and their outputs are fed to transistors Tr1 and Tr2 through capacitors C1 and C2, respectively. The transistors Tr1 and Tr2 are adapted to rectify oscillator outputs and have smoothing capacitors C3 and C4 interposed between the collector terminal and the earth terminal. The terminal voltages of capacitors C3 and C4 are fed to waveform trimming circuits 3 and 4, respectively, and the respective outputs are fed to a disagreement judging circuit 5. The capacitors C1 and C3 and transistors Tr1 and the capacitors C2, C4 and transistor Tr2 constitute the first and second oscillation judging circuit 6 and 7 for judging the oscillation states of oscillation circuits 1 and 2, respectively. The waveform trimming circuits 3 and 4 are adapted to differentiate the respective rectified outputs using a predetermined threshold value. The output terminals of waveform trimming circuits 3 and 4 are connected to output circuit 8 to form a wired OR circuit in such a manner that OR outputs are fed to output circuit 8. The output circuit 8 reverses this OR signal and outputs an object detection signal. The wired OR circuit and the output circuit 8 constitute the signal output means for outputting said object detection signal. The disagreement judging circuit 5 is adapted to detect a disagreement between the terminal voltages of the capacitor C3 and C4 and, when these outputs are continually not in agreement, outputs a fault detection signal. Connected to this disagreement judging circuit 5 is a pilot lamp 9 which indicates such a disagreement when it is the case. On the other hand, the output circuit 8 is adapted to output an object detection signal according to the OR signal and is connected to a pilot lamp 10 which illuminates on detection of an object.

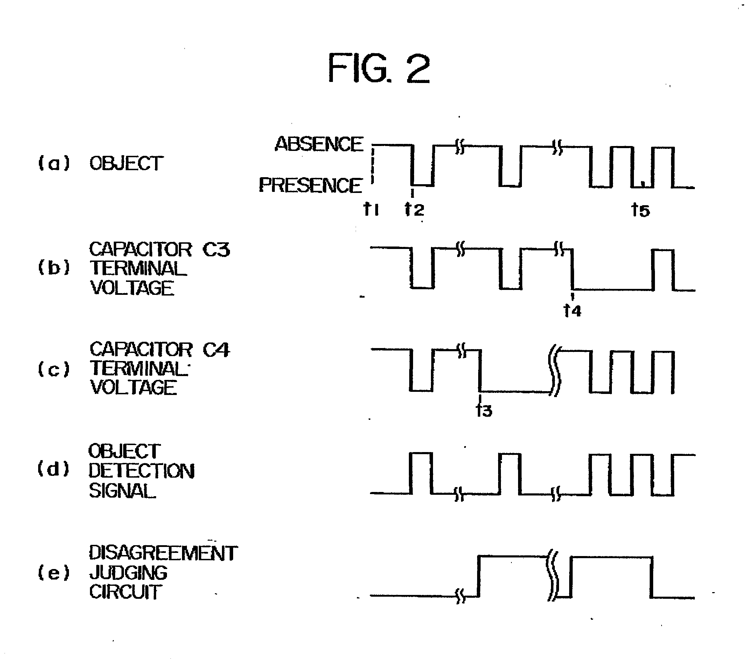

The operation of the above embodiment is explained below, reference being given to the time chart of Fig. 2. As shown in Fig. 2(a) through (c), when there is no object at a time $t_1$, the oscillation circuits 1 and 2 keep oscillating because of the absence of capacitance loss in detection coils L1 and L2 so that oscillation outputs of a predetermined level are available from oscillation circuits 1 and 2. As these outputs are rectified by transistors Tr1 and Tr2 via capacitors C1 and C2, respectively, the terminal voltages are at HIGH level. These outputs are fed to the waveform trimming circuits 3 and 4 and, then, to the disagreement judging circuit 5. The waveform trimming circuits 3 and 4 trim the respective output signal and feed the OR thereof to the output circuit 8. When an object approaches at time $t_2$, the oscillation circuits 1 and 2 stop oscillating under normal conditions. As a result, the terminal voltages of capacitors C3 and C4 drop and the level of OR output obtained by trimming the capacitor outputs becomes LOW. Therefore, as the output circuit 8 reverses this output, an object detection signal illustrated in Fig. 2(d) is outputted. Since the terminal voltage levels at capacitors C3 and C4 become low almost concurrently in this case, too, no differentiation output is available from the disagreement judging circuit 5.

In this event the detection coil L2 is broken or the oscillation circuit 2 stops oscillating due to some fault, the oscillation circuit 2 stops oscillating and remains in that state irrespective of the presence or absence of an object as shown at time $t_3$ and during the subsequent period as shown in Fig. 2(c). If the detection coil L1 and oscillation circuit 1 are operat ing properly, the oscillation takes place as shown in Fig. 2(b) in response to the approach of an object. Therefore, according to the OR output, an object detection signal represented by Fig. 2(d) is outputted from the output circuit 8. However, after time $t_3$, because of a disagreement between the terminal voltages of capacitors C3 and C4, a fault detection signal is available from the disagreement judging circuit 5. At this moment, the pilot lamp 9 illuminates to indicate the occurrence of a fault.

Even when the detection coil L1 breaks or the oscillation circuit 1 fails to keep oscillating for some cause or other as shown at time $t_4$ and thereafter, an object detection signal is available from the output circuit 9 as long as the oscillation circuit 2 keeps oscillating upon approach of an object. Moreover, a the outputs of oscillation circuits 1 and 2 are differentiated by the disagreement judging circuit 5, a fault detection signal is also available. Then, if a normal state resumes at time $t_5$, an agreement between outputs is reestablished so that the fault detection signal ceases to be outputted.

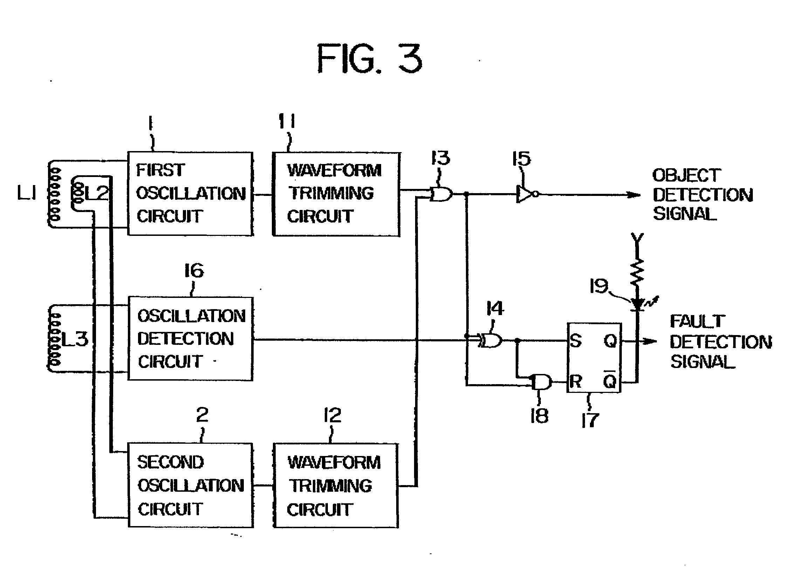

Fig. 3 is a block diagram showing the construction of a proximity switch of the second embodiment. In Figs. 1 and 3, the like numerals are used to denote the like parts. In this embodiment, the outputs of oscillation circuits 1 and 2 are directly fed to waveform trimming circuits 11 and 12, respectively. The waveform trimming circuits 11 and 12 are oscillation differentiating means adapted to rectify the oscillation outputs of oscillation circuits 1 and 2 and differentiates the outputs with a predetermined threshold value and the respective outputs are fed to an OR circuit 13. The OR circuit 13 takes the OR output of waveform trimming circuits 11 and 12 to provide an object detection signal and this output is fed to an exclusive OR circuit (hereinafter referred to as EOR circuit) 14 and, also, is outputted through an inverter 15. In addition, a pickup coil L3 is disposed near the detetion coil L1 and L2 and both terminals of the pickup coil L3 are connected to the oscillation detection circuit 16. The oscillation detection circuit 16 applies an output of H level to the EOR circuit 14 when it detects the oscillation. The EOR circuit 14 feeds the exclusive OR output as a fault differentiation signal to the set input terminal of an RS flip-flop 17 and the reversal input terminal of an AND circuit 18. The output of OR circuit 13 is fed to the other input terminal of the AND circuit 18. The AND circuit 18 detects the release of the proximity switch to the normal condition from the AND signal and its output is fed to the reset input terminal of the RS flip-flop 17. The RS flip-flop 17 retains the fault differentiation output even if there is no longer an object nearby after finding of a fault and outputs a fault detection signal from its Q terminal. Connected to this flip-flop 17 is a light-emitting diode 19 which illuminates upon finding of a fault.

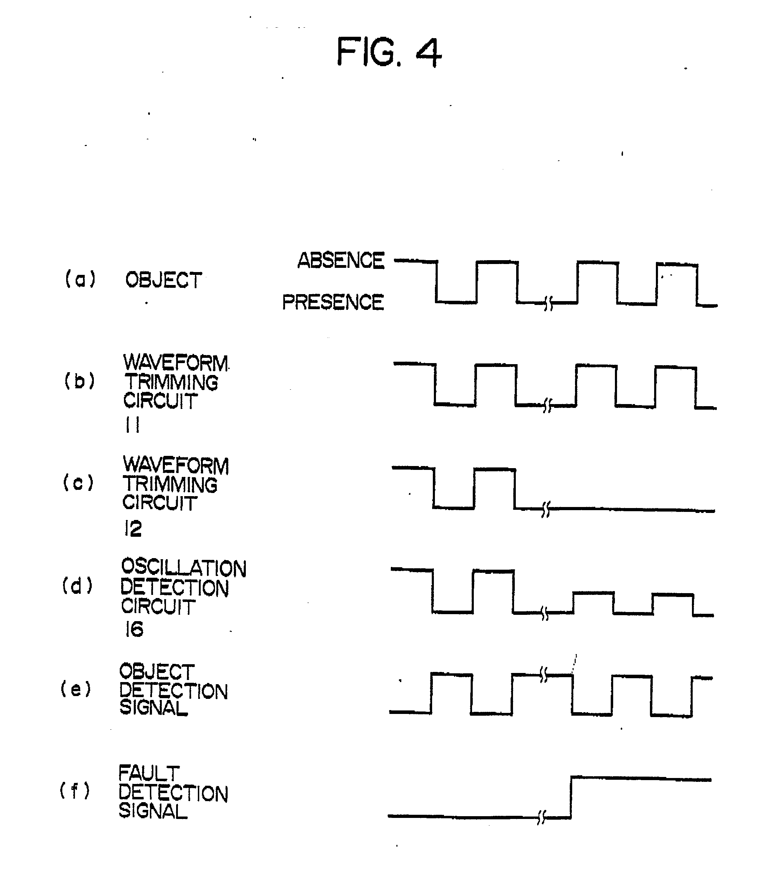

The operation of this embodiment is explained below, reference being given to the time chart of Fig. 4. As in the first embodiment described hereinbefore, the oscillation circuits 1 and 2 oscillates or stop oscillating in accordance with the absence or presence of an approaching object. In the present embodiment, these oscillation outputs are detected by an oscillation detection circuit 16 via pickup coil L3. When both oscillation circuits 1 and 2 are oscillating in the absence of an object, the threshold value is exceeded so that a signal of H level is available from the OR circuit 13. As an object approaches, the oscillation circuits 1 and 2 stop oscillating almost concurrently and the oscillation detection circuit 16 also ceases to detect. oscillations, so that an object detection signal shown in Fig. 4(e) is available according to the reversed output of OR circuit 13. Then, the OR output from waveform trimming circuits 11 and 12 and the output of oscillation detection circuit 16 are in agreement so that no fault detection signal is available from the EOR circuit 14.

However, as shown in Fig. 4(c) and (d), if the detection coil L2 breaks or the oscillation circuit 2 fails and stops oscillating, the detection level of the oscillation detection circuit 16 is decreased even when the oscillation circuit 1 keeps oscillating in the absence of an object so that an output of L level is applied to the EOR circuit 14. Therefore, in the event of disagreement with the output of the OR circuit 13, the flip-flop 17 is set as shown in Fig. 4(f) to output a fault detection signal. And even if the two oscillation circuits are not oscillating in the presence of an object, the fault detection signal continues to be outputted from the flip-flop 17. If this proximity switch is reset to a normal state, the object detection output of the OR circuit 13 and the output of the oscillation detection circuit 16 are brought into agreement so that the AND circuit 18 feeds a reset signal to the RS flip-flop 17 to stop outputting of the fault detection signal. The same trouble-shooting routine applies to the case in which the other detection coil L1 or oscillation circuit 1 has failed.

Thsu, the present invention empolying two sets of circuits outputs a fault detection signal in the event of disagreement of outputs from the respective sets of circuits and even in the event of such a fault, can continue to output a normal object detection signal.

The above description and the accompanying drawings are merely illustrative of the application of the principles of the present invention and are not limiting. Numerous other arrangements which employ the principles of the invention and which fall within its spirit and scope may be readily devised by those skilled in the art. Accordingly, the invention is not limited by the foregoing description, but only limited by the scope of the appended claims.

## Claims

1. A self-diagnosing proximity switch comprising
a first and second detection coils,
a first and a second oscillation circuits connected to said first and second detection coil, respectively,
a first and a second oscillation judging means adapted to judge the state of oscillation of said first and second oscillation circuits;
a disagreement judging circuit adapted to output a fault detection signal upon finding of disagreement between outputs of said first and second oscillation judging means and

an output means adapted to output an object detection signal according to the OR output of said first and second oscillation judging means.

2. A self-diagnosing proximity switch comprising
a first and a second detection coils,
a first and a second oscillation circuits connected to said first and second detection coils, respectively,
a pickup coil disposed adjacent said first and second detection coils,
an oscillation detection circuit adapted to detect the oscillations of both of said first and second oscillation circuits according to the signal level available at said pickup coil,
a first and a second oscillation judging means adapted to judge the state of oscillation of said first and second oscillation circuits, respectively,
a signal output means adapted to output an object detection signal according to the OR output of said first and second means, and
an exclusive OR circuit which judges a fault according to the exclusive OR output of said output means and oscillation detection circuit.

## FIG. 1

Block diagram showing: 1 FIRST OSCILLATION CIRCUIT and 2 SECOND OSCILLATION CIRCUIT connected to coils L1, L2. Block 6 (Tr1, C1, C3) and block 7 (Tr2, C2, C4) feed into 3 WAVEFORM TRIMMING CIRCUIT and 4 WAVEFORM TRIMMING CIRCUIT. These connect to 8 OUTPUT CIRCUIT producing OBJECT DETECTION SIGNAL (10), and 5 DISAGREEMENT JUDGING CIRCUIT producing FAULT DETECTION SIGNAL (9).

# FIG. 2

(a) OBJECT

(b) CAPACITOR C3 TERMINAL VOLTAGE

(c) CAPACITOR C4 TERMINAL VOLTAGE

(d) OBJECT DETECTION SIGNAL

(e) DISAGREEMENT JUDGING CIRCUIT

EP 0 360 263 A2

# FIG. 3

EP 0 360 263 A2

# FIG. 4

(a) OBJECT

ABSENCE

PRESENCE

(b) WAVEFORM TRIMMING CIRCUIT 11

(c) WAVEFORM TRIMMING CIRCUIT 12

(d) OSCILLATION DETECTION CIRCUIT 16

(e) OBJECT DETECTION SIGNAL

(f) FAULT DETECTION SIGNAL